Europäisches Patentamt

European Patent Office

Office européen des brevets

(19)

(11) **EP 1 170 870 A1**

(12) **EUROPEAN PATENT APPLICATION**
published in accordance with Art. 158(3) EPC

(43) Date of publication:
**09.01.2002 Bulletin 2002/02**

(21) Application number: **01904429.6**

(22) Date of filing: **14.02.2001**

(51) Int Cl.7: **H03M 13/09**, H03M 13/23, H03M 13/27, H03M 13/39, H04L 1/22

(86) International application number:
**PCT/JP01/01030**

(87) International publication number:
**WO 01/61867 (23.08.2001 Gazette 2001/34)**

(84) Designated Contracting States:
**AT BE CH CY DE DK ES FI FR GB GR IE IT LI LU MC NL PT SE TR**
Designated Extension States:
**AL LT LV MK RO SI**

(30) Priority: **15.02.2000 JP 2000036814**
**16.02.2000 JP 2000037593**
**16.02.2000 JP 2000037594**

(71) Applicant: **Kawasaki Steel Corporation**
**Kobe-shi, Hyogo 651-0075 (JP)**

(72) Inventors:
• **SUZUKI, Hiroshi**
  **Irvine, CA 92606 (US)**
• **KONDO, Hisashi,**
  **c/o KAWASAKI STEEL CORPORATION**
  **Tokyo 100-0011 (JP)**

(74) Representative: **Stebbing, Timothy Charles**
**Haseltine Lake & Co., Imperial House, 15-19 Kingsway**
**London WC2B 6UD (GB)**

(54) **TURBO DECODER**

(57)     An object is to provide a turbo decoder in which a reduction in power consumption is achieved. In a turbo decoder 1 to which turbo decoded data is input in block units and which carries out turbo decoding, by referring to a look-up table 21, a number of repeating times, which corresponds to a signal-to-noise ratio estimated at a root mean square circuit 20, is estimated. By decrementing at a counter section 22, turbo decoding is carried out the number of repeating times.

Fig. 1

EP 1 170 870 A1

**Description**

Technical Field

The present invention relates to a turbo decoder to which turbo encoded data is input in block units, and which carries out turbo decoding.

Background Art

In recent years, attention has been paid to communications systems using turbo encoders and turbo decoders in order to improve the error correcting ability at a communication path of mobile communications or the like at which a state (fading), in which the strength of received waves varies rapidly, has arisen.

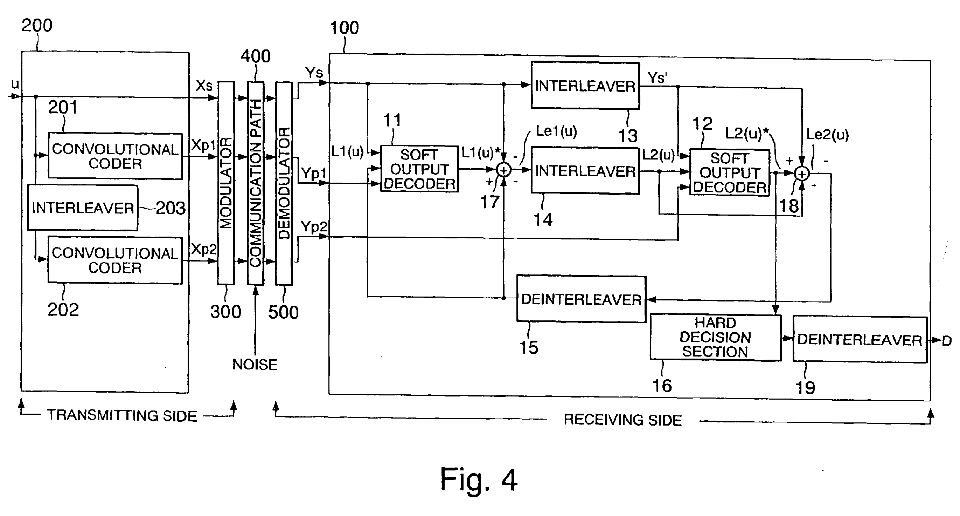

Fig. 4 is a diagram showing a conventional circuit structure in a communications system using a turbo encoder and a turbo decoder.

In Fig. 4, a turbo encoder 200 and a modulator 300 on a transmitting side, and a communication path 400, and a demodulator 500 and a turbo decoder 100 on a receiving side, are shown.

The turbo encoder 200 includes convolutional coders 201, 202 and an interleaver 203. A binary variable u = $(u_1, u_2, ..., u_N)$ which expresses information bit is input to the turbo encoder 200. The input binary variable u is output as is as transmission data $X_s = (X_1{}^s, X_2{}^s, ..., X_N{}^s)$. and is also input to the convolutional coder 201 and the interleaver 203.

In the convolutional coder 201, a delay circuit and exclusive OR gate (not shown) are included. The convolutional coder 201 delays the input binary variable u one bit by one bit at the delay circuit, and calculates the binary variable delayed one bit by one bit at the exclusive OR gate, and then generates encoded data (convolutional code) $X_{p1} = (X_1{}^{p1}, X_2{}^{p1}, ..., X_N{}^{p1})$ having a sequential relationship over time.

The interleaver 203 successively writes the input binary variables u into a memory, reads out the written binary variables u according to a predetermined algorithm, and then inputs them to the convolutional coder 202.

In the same way as the convolutional coder 201 described above, the convolutional coder 202 delays the data from the interleaver 203 and carries out exclusive OR operation and generates encoded data (convolutional code) $X_{p2} = (X_1{}^{p2}, X_2{}^{p2}, ..., X_N{}^{p2})$.

The transmission data $X_s$ and the encoded data $X_{p1}$, $X_{p2}$ output from the turbo encoder 200 are input to the modulator 300. The modulator 300 modulates the input transmission data $X_s$ and encoded data $X_{p1}$, $X_{p2}$ by a modulation method such as a two-phase phase modulating method (BPSK: Binary Phase Shift Keying) or a four-phase phase modulating method (QPSK: Quadrature Phase Shift Keying) or the like, and sends the data to the communication path 400.

At the communication path 400, noise is mixed in, and the transmission data $X_s$ and the encoded data $X_{p1}$, $X_{p2}$ including noise are input to the demodulator 500.

In the demodulator 500, these received data are processed by soft decision. In Soft decision processing, the voltage level of a demodulated signal is mapped to several levels that are three or more levels, and is output. For example, the voltage level is distributed into 8 types of multivalue data (0, 1, ... 7), and is output. The received data $Y_s$ = $(Y_1{}^s, Y_2{}^s, ..., Y_N{}^s)$ and the coded data $Y_{p1} = (Y_1{}^{p1}, Y_2{}^{p1}, ... Y_N{}^{p1})$, $Y_{p2} = (Y_1{}^{p2}, Y_2{}^{p2}, ... Y_N{}^{p2})$ corresponding to the transmitted data $X_s$ and the encoded data $X_{p1}$, $X_{p2}$, which have been subjected to soft decision processing in this way, are output from the demodulator 500. The received data $Y_s$ and encoded data $Y_{p1}$, $Y_{p2}$ are input to the turbo decoder 100.

The turbo decoder 100 includes soft output decoders 11, 12, interleavers 13, 14, deinterleavers 15, 19, a hard decision section 16, and computing units 17, 18. MAP (Maximum A Posteriori) decoding or SOVA (Soft Output Viterbi Algorithm) or the like is used as the algorithm of the soft output decoding. Hereinafter, a case using MAP decoding as the algorithm of soft output decoding is used as an example, and a summary thereof will be described. For details, refer to "A Turbo Code Tutorial" William E. Ryan, New Mexico State University, Box 30001 Dept. 3-0, Las Cruces, NM 88003 "An Overview of Turbo Codes" /www.ee.virginia.edu/ccsp/turbo_codes/, or "A Guide to Shannon Limit: "parallel concatenated (Turbo) coding", "turbo (interative) decoding", and peripheries thereof" Motohiko Isaka, Hideki Imai, TECHNICAL REPORT OF IEICE IT98-51 (1998-12), THE INSTITUTE OF ELECTRONICS, INFORMATION AND COMMUNICATION ENGINEERS.

Hereinafter, first, in order to understand decoding of a turbo code, what type of reliability information (referred to as likelihood information) is used will be explained. For simplicity, the received data $Y_s$ and the encoded data $Y_p$ are represented as Y = $(Y_s, Y_p)$. Here, $Y_p$ consists of parity inputs, $Y_{p1}$ or $Y_{p2}$, of the soft output decoder. In the MAP decoder, it is determined whether the decode results (results of decoding) $u_k$ are $u_k = +1$ or $u_k = -1$, according to the following logarithm likelihood ratio $L_k(u_k)$. Here, the subscript k represents the time k (the kth data in time sequence data).

$$L_k(u_k) = \log P(u_k = +1|Y)/P(u_k = -1|Y)$$

Here, $P(u_k = +1|Y)$ represents the probability that the decode results (results of decoding) are $u_k = +1$ at the time when $Y = (Y_s, Y_p)$, and $P(u_k = -1|Y)$ represents the probability that the decode results (results of decoding) are $u_k = -1$ at the time when $Y = (Y_s, Y_p)$.

When an additive algorithm is used, the log-likelihood ratio is calculated as follows. $S_k$ is the state at time k. $S_k$ is a value from 0 to $2^M-1$. M is the number of stored elements in the encoder..The branch metrics in the case when the state changes from $S_{k-1}$ to $S_k$ is calculated as follows.

$$\gamma_l(y_k, S_{k-1}, S_k) = 1/2_L\ L^{\sigma}{}_M(u_k)u_k + L_c y_k^s u_k + L_c y_k^p x_k^p \,\cdot$$

$L^{\sigma}{}_M$ is the priori information likelihood which is calculated at the soft output decoder 12 in the case of the soft output decoder 11, or calculated at the soft output decoder 11 in the case of the soft output decoder 12. $L_c$ is a constant that is determined by the signal-to-noise ratio, and $L_c = 4E_c/No$. $E_c$ is the energy for each encoded bit, and No is the noise spectrum density. The forward recursive state metrics and the backward recursive state metrics are calculated by the following formulas:

$$\alpha_k\left(S_k\right) = \overline{\max_{\left(S_{k-1},l\right)}}\ \left(\gamma_l\left(y_k, S_{k-1}, S_k\right) + \alpha_{k-1}\left(S_{k-1}\right)\right)$$

$$\beta_k\left(S_k\right) = \overline{\max_{\left(S_{k-1},i\right)}}\ \left(\gamma_i\left(y_{k-1}, S_k, S_{k+1}\right) + \beta_{k+1}\left(S_{k-1}\right)\right)$$

wherein max is the following maximum value function with a correction term.

$$\overline{\max_l} A_l = A_M + \log\left(1 + \sum_{i=M} \exp\left(A_l - A_M\right)\right)$$

$$A_M = \max_l A_l$$

The correction term is realized by using a small look-up table. Finally, the log-likelihood ratio is calculated as follows.

$$L_R\left(u_k\right) = \overline{\max_{\left(S_{k-1},S_k\right)}}\left(\gamma_l\left(y_k, S_{k-1} S_k\right) + \alpha_{k-1}\left(S_{k-1}\right) + \beta_k\left(S_k\right)\right)$$
$$- \overline{\max_{\left(S_{k-1},S_k\right)}}\left(\gamma_0\left(y_k, S_{k-1}, S_k\right) + \alpha_{k-1}\left(S_{k-1}\right) + \beta_k\left(S_k\right)\right)$$

In the decoding of the turbo code, the log-likelihood ratio is divided into three terms.

$$L_R(u_k) = L_c y_k^s + L_{in}^{\sigma}(u_k) + L_{ow}^{\sigma}(u_k)$$

The final term is referred to the external likelihood information, and is a value calculated from only parity information. Only this external likelihood information is fed-back to the soft output decoder 11 as priori likelihood information.

Next, the structure of the turbo decoder 100 will be described.

Received data $Y_s$, encoded data $Y_{p1}$, and priori likelihood information $L_1(u)$ that is feedback information from the deinterleaver 15 are input to the soft output decoder 11 forming the turbo decoder 100. At an initial state, the value of the priori likelihood information $L_1(u)$ is '0'. At the soft output decoder 11, a constant $L_c$ is multiplied by the received

data $Y_s$, and a communication path value $L_c \cdot Y_s$ is estimated. On the basis of the communication path value $L_c \cdot Y_s$ and the encoded data $Y_{p1}$, soft output data $L_1(u)^*$ is output. Here, * denotes that the signal is delayed in time with respect to the input. Note that the constant $L_c$ is set by a control processor (not shown) according to the magnitude of the signal-to-noise ratio at the communication path 400.

The computing unit 17 subtracts the communication path value $L_c \cdot Y_s$ from the input soft output data $L_1(u)^*$, and estimates external likelihood information $Le_1(u)$. Specifically, in a case in which only small noise is included in the received data $Y_s$ and the reliability of the received data $Y_s$ is high, the relatively large value is set as constant $L_c$. Thus, by using the large communication path value $L_c \cdot Y_s$, the soft output data $L_1(u)^*$ is calculated, and turbo decoding is carried out mainly with the received data $Y_s$. On the other hand, in a case in which large noise is included in the received data $Y_s$ and the reliability of the received data $Y_s$ is low, the relatively small value is set as the constant $L_c$. Thus, by using the small communication path value $L_c \cdot Y_s$, the soft output data $L_1(u)^*$ is calculated, and turbo decoding is carried out mainly with the soft output data $L_1(u)^*$.

The interleaver 14 successively writes the external likelihood information $Le_1(u)$ from the computing unit 17 into a memory in the interleaver 14, and then estimates priori likelihood information $L_2(u)$ by reading from this memory by the same algorithm as the one in the interleaver 203 described above. This priori likelihood information $L_2(u)$ is external likelihood information given from the soft output data $L_1(u)^*$ obtained at the soft output decoder 11.

The interleaver 13 successively writes the received data $Y_s$ into a memory in the interleaver 13, and then outputs received data $Y_s'$ from the memory by reading by the same algorithm as the one in the interleaver 203 described above.

The received data $Y_s'$ and the priori likelihood information $L_2(u)$ are input from the interleavers 13, 14 to the soft output decoder 12. Further, the encoded data $Y_{p2}$ is also input from the demodulator 500. Because the encoded data $Y_{p2}$ is data generated through the interleaver 203 as described above, its sequence corresponds to that of the received data $Y_s'$ and the priori likelihood information $L_2(u)$. The soft output decoder 12 multiplies the constant $L_c$ by the received data $Y_s'$, and estimates a communication path value $L_c \cdot Y_s'$. Moreover, synchronously therewith, the soft output decoder 12 multiplies the constant $L_c$ by the encoded data $Y_{p2}$ and estimates a communication path value $L_c \cdot Y_{p2}$. On the basis of these communication path values $L_c \cdot Y_s'$, $L_c \cdot Y_{p2}$ and the priori likelihood information $L_2(u)$, the soft output decoder 12 outputs soft output data $L_2(u)^*$. The output soft output data $L_2(u)^*$ is input to the hard decision section 16 and the computing unit 18.

The hard decision section 16 processes a hard decision in which value of the binary data the multivalue soft output data $L_2(u)^*$ belongs to, and outputs binary data D through the deinterleaver 19. In a case that decoding results are estimated by single series of this process, the process is terminated at this moment, but generally, the turbo decoder 100 repeats the above processes n times (n = 2, 3, ...) and estimates the decoding results, and thus, the following operations are carried out.

The soft output data $L_2(u)^*$, the received data $Y_s'$, and the priori likelihood information $L_2(u)$ are input to the computing unit 18. On the basis of the received data $Y_s'$ and the priori likelihood information $L_2(u)$, the computing unit 18 subtracts the soft output data $L_2(u)^*$, and estimates the external likelihood information $Le_2(u)$. This external likelihood information $Le_2(u)$ is external likelihood information that is estimated from the n-1th results of decoding from the soft output decoder 12. This external likelihood information $Le_2(u)$ is input to the deinterleaver 15.

The deinterleaver 15 processes the input external likelihood information $Le_2(u)$ by an algorithm which is the inverse of the previously described algorithm, and converts to the same order as the received data $Y_s$, and estimates the the advance likelihood information $L_1(u)$, and feedbacks to the soft output decoder 11 and the computing unit 17.

In this way, at the turbo decoder 100, due to the two soft output decoders repeatedly feeding back the priori likelihood information $L_1(u)$, $L_2(u)$ and carrying out decoding, the data error correction ability can be improved. Moreover, by reordering the data in the interleave processing, data errors due to noise generated at specific portions of the communication path 400 can be corrected with high accuracy.

The signal-to-noise ratio of the data at the communication path varies from time to time. However, at the above-described turbo decoder 100, the number of iteration of the decoding may be set considering the worst signal-to-noise ratio. Thus, in a case in which a block having a relatively high signal-to-noise ratio is received, excessive repetition is carried out at the turbo decoder 100. This causes the problems such as low processing speed and extra power consumption.

A turbo decoder that achieves low power consumption has been proposed in a recently published thesis ("Reducing Power Consumption of Turbo Code Decoder Using Adaptive Iteration with Variable Supply Voltage", Proc. IEEE Intnl. Symp. on Low Power Design, San Diego CA, pp. 76-81, Aug. 1999).

The turbo decoder carries out error correction processing and CRC check by repeating turbo decoding, and in a case of judging that there exist no errors, terminates the iteration process and estimates the results of decoding. However, in a case the received data sequence has relatively low signal-to-noise ratio, the repeating of turbo decoding is carried out many times until CRC check determines error-free, and the reduction of power consumption is deficient.

Moreover, a technique is proposed in Japanese Patent Application Laid-Open (JP-A) No. 10-303759 in which input soft decision data is decoded in bit series by a Viterbi decoder, and reliability information is added to each bit of the decoded bit series, and a data sequence is estimated and CRC checked. In a case of error-free, the data sequences are output as the results of decoding, whereas in a case of erroneous data, in the descent order of the total sum of the reliability information, bit reversal is carried out until it is judged that there are no errors, and the results of decoding are estimated. However, in this technique, reliability information is added to the decoded bit series and CRC check is carried out. Thus, a long time is required for CRC check, and accordingly, a problem arises in that it lowers the processing speed for estimation of the results of decoding.

Moreover, the above-described constant $L_c$ used in branch metrics calculation is determined from the magnitude of the signal-to-noise ratio of the communication path 400 (the constant $L_c$ is set low in a case of high signal-to-noise ratio, and the constant $L_c$ is set high in a case of low signal-to-noise ratio). Usually, a control processor (not shown) calculates the constant $L_c$ by information obtained from the demodulator 500, and sets the constant $L_c$ at the turbo decoder 100.

Actually, the received data $Y_s$ output from the demodulator 500 is not directly transferred to the turbo decoder 100, but is sent to the turbo decoder 100 after several processes such as quantization, saturation processing, truncating of lower bits, have been carried out. At this time, when a difference arises between the constant $L_c$, which is calculated by the control processor by information obtained from the demodulator 500, and the constant $L_c$, which actually should be used at the turbo decoder 100, problems arise in that the accuracy of the results of decoding deteriorates, and accordingly, the error correction ability deteriorates. Further, there is a problem in that a portion of the processing capacity of the control processor is used in order to calculate the constant $L_c$, and there is less processing capacity that can be used for other calculations.

Disclosure of the Invention

In view of the above-described circumstances, an object of the present invention is to provide a turbo decoder in which an improvement in processing speed and a reduction in power consumption are realized, while deterioration in the error correction ability is suppressed.

In a turbo decoder to which turbo encoded data is input in block units and which carries out turbo decoding, a first turbo decoder, among the turbo decoders of the present invention that achieve the above object, comprises:

a decoding section to which data is input and which carries out turbo decoding; and a signal-to-noise ratio estimation section which, based on reliability information output of the decoding section, estimates a signal-to-noise ratio of a block under processing,

wherein the decoding section carries out iterative turbo decoding process by a number of times corresponding to the signal-to-noise ratio estimated at the signal-to-noise ratio estimation section.

The first turbo decoder of the present invention estimates, based on the reliability information output of the decoding section, the signal-to-noise ratio of the block under processing, and carries out turbo decoding a number of times corresponding to the signal-to-noise ratio. Thus, in a case in which a block containing less noise is received, turbo decoding is carried out a smaller number of times . Accordingly, as compared with a conventional turbo decoder in which the number of iteration is set considering the worst signal-to-noise ratio, in a case in which a block having a comparatively high signal-to-noise ratio is received, excessive repetitions are prevented, and an improvement in the processing speed and a reduction in power consumption are realized without bringing about a deterioration in the error correction ability.

Here, in the above-described first turbo decoder of the present invention, it is preferable that the signal-to-noise ratio estimation section has a root mean square circuit that calculates root mean square of soft output data or external likelihood information, and estimates the signal-to-noise ratio of the block under processing.

Moreover, in the above-described first turbo decoder, it is a preferable aspect that the turbo decoder has a comparing section that compares the signal-to-noise ratio and a predetermined value, and the decoding section repeats turbo signal until the signal-to-noise ratio estimated by the signal-to-noise ratio estimation section reaches the predetermined value.

Further, the above-described first turbo decoder may have a look-up table that stores a correspondence relation between signal-to-noise ratios and numbers of repetition of turbo decoding, and the decoding section may repeat turbo decoding by a number of times corresponding to the signal-to-noise ratio estimated by the signal-to-noise ratio estimation section, according to the look-up table.

Further, the above-described first turbo decoder may have a counter section that counts a number of times turbo decoding is repeated, and the decoding section may terminate hard decision, after a number of times corresponding to the signal-to-noise ratio estimated by the signal-to-noise ratio estimation section has been counted at the counter section.

In a turbo decoder to which turbo encoded data is input in block units and which carries out turbo decoding, a second turbo decoder, among the turbo decoders of the present invention that achieve the above object, comprises:

a decoding section to which data is input and which carries out turbo decoding;
a signal-to-noise ratio estimation section which, based on reliability information output of the decoding section, estimates a signal-to-noise ratio of a block under processing; and
an input level adjustment section that adjusts a level of data input to the decoding section according to the signal-to-noise ratio estimated by the signal-to-noise ratio estimation section.

The second turbo decoder of the present invention estimates, based on reliability information output of the decoding section, the signal-to-noise ratio of the block under processing, and adjusts the level of the input data according to the signal-to-noise ratio. Thus, based on the reliability output information in the turbo decoder, the signal-to-noise ratio of the block that is currently under processing is estimated, and a constant $L_c$, which is determined by the signal-to-noise ratio of the input data, is appropriately set automatically. Accordingly, there is no deterioration in the error correction ability due to the difference between the constant $L_c$ calculated by the control processor and the constant $L_c$ actually used at the turbo decoder, as in the conventional turbo decoder. Moreover, the processing ability for calculating the constant $L_c$ can be prevented from deteriorating, and an increase in the processing ability and a reduction in power consumption can be achieved.

Here, in the above-described second turbo decoder of the present invention, it is preferable that the input level adjustment section amplifies the data at a low amplification rate in a case in which the reliability of data input to the decoding section is relatively low, and at a high amplification rate in a case in which the reliability is relatively high.

In the above-described second turbo decoder, the signal-to-noise ratio estimation section may have a root mean square circuit that operates root mean square of soft output data or external likelihood information and estimates the signal-to-noise ratio of the block under processing.

Further, in the above-described second turbo decoder, it is a preferable aspect that the turbo decoder has a look-up table that stores a correspondence relationship between signal-to-noise ratios and ratios of input data to external likelihood information (IER; Input to Extrinsic data Ratio), and the input level adjustment section adjusts the level of the data input to the decoding section according to the signal-to-noise ratio estimated by the signal-to-noise ratio estimation section, in accordance with the look-up table.

Further, in a turbo decoder to which turbo encoded data is input in block units and which carries out turbo decoding, a third turbo decoder, among the turbo decoders of the present invention that achieve the above object, comprises:

a repeat decoding section to which data sequences are input and which repeats, a plural number of times, a decoding process accompanying a soft decision;
a hard decision section that generates a decoded data sequence by receiving soft decision results of decoding at the repeat decoding section and carrying out hard decision;
a CRC check section that carries out CRC check for the decoded data sequence obtained at the hard decision section; and
a low reliability data position storing section that stores a low reliability data position among the soft decision results of decoding at the repeat decoding section,

wherein the CRC check section carries out CRC check on the decoded data sequence obtained at the hard decision section, and based on the decoded data sequence, carries out CRC check also on a data sequence at which a logic of data of the low reliability data position stored in the low reliability data position storing section, among the decoded data sequence, is inverted.

The third turbo decoder of the present invention inverts the logic of the data of the low reliability data position among the soft decision results of decoding, estimates a data sequence, and carries out CRC check. Thus, for example, in a case in which noise is included in a portion of the data sequence due to the generation of fading, the logic of only data that includes noise among the data sequence is inverted and CRC check is carried out. Accordingly, the probability that it will be judged that there are no errors in the CRC check increases. As compared with the technique proposed in the above-mentioned thesis (1999 IEEE Intnl. Symp. on Low Power Design), the time until it is judged that there are no errors in the CRC check is shortened, and while a deterioration in the error correcting ability is suppressed, an improvement in the processing speed and a further reduction in the power consumption are achieved. Moreover, as compared with the technique proposed in Japanese Patent Laid-open Gazette No. 10-303759 in which soft decision data is decoded into a bit sequence and reliability information is added to the bit sequence and CRC check is carried out, the time required for carrying out CRC check is shortened, and from this standpoint, an improvement in the processing speed until the results of decoding are estimated is achieved.

Here, it is preferable that, each time the repeat decoding section repeats the decoding process, the low reliability data position storing section stores a low reliability data position among the soft decision results at a repeat process of this time, and

the CRC check section inverts the logic of the data of the data position stored at a repeat process of a previous time in the low reliability data position storing section, among the decoded data sequence obtained by the hard decision section, and carries out CRC check, and
the turbo decoder comprises a repeat control section which, in a case in which a data sequence is obtained for which it is judged that there are no errors in CRC check results at the CRC check section, terminates repeating of the decoding process at the repeat decoding section.

In this way, the storing of the low reliability data position and the CRC check can be carried out simultaneously. Further, in a case in which it is judged that there are no errors in the CRC check results, the repeating of the decoding process can be terminated immediately. Therefore, the results of decoding can be estimated in an even shorter time, and a further improvement in processing speed and a further reduction in power consumption are achieved.

As described above, according to the present invention, while a deterioration in the error correction ability is suppressed, an improvement in processing speed and a reduction in power consumption are achieved.

Brief Description of the Drawings

Fig. 1 is a block diagram of a turbo decoder of a first embodiment of the present invention.
Fig. 2 is a block diagram of a turbo decoder of a second embodiment of the present invention.
Fig. 3 is a block diagram of a turbo decoder of a third embodiment of the present invention.
Fig. 4 is a diagram showing a conventional turbo decoder, and a circuit structure in a communication system using the turbo decoder.

Best Mode for Carrying out the Invention

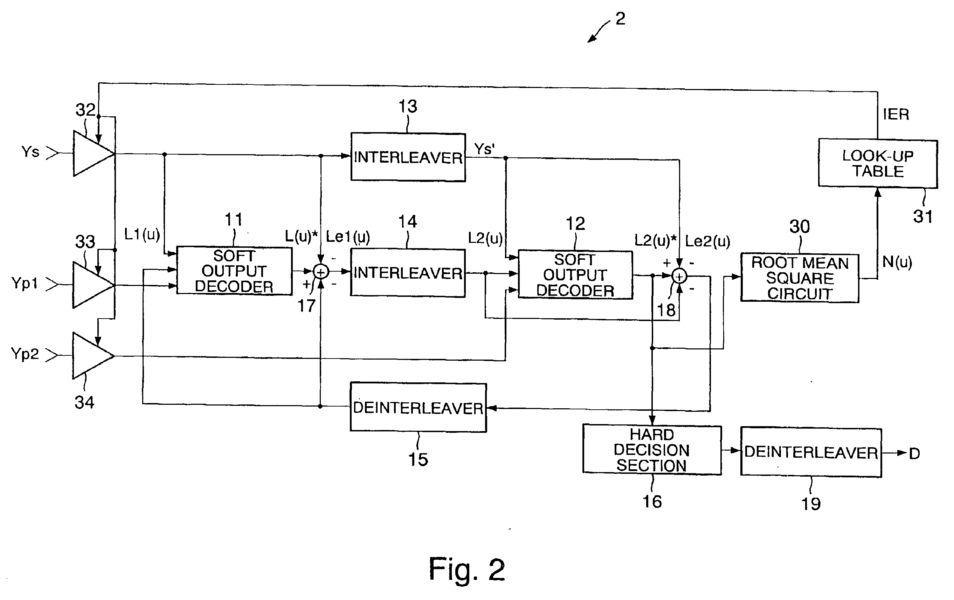

Hereinafter, embodiments of the present invention will be described.

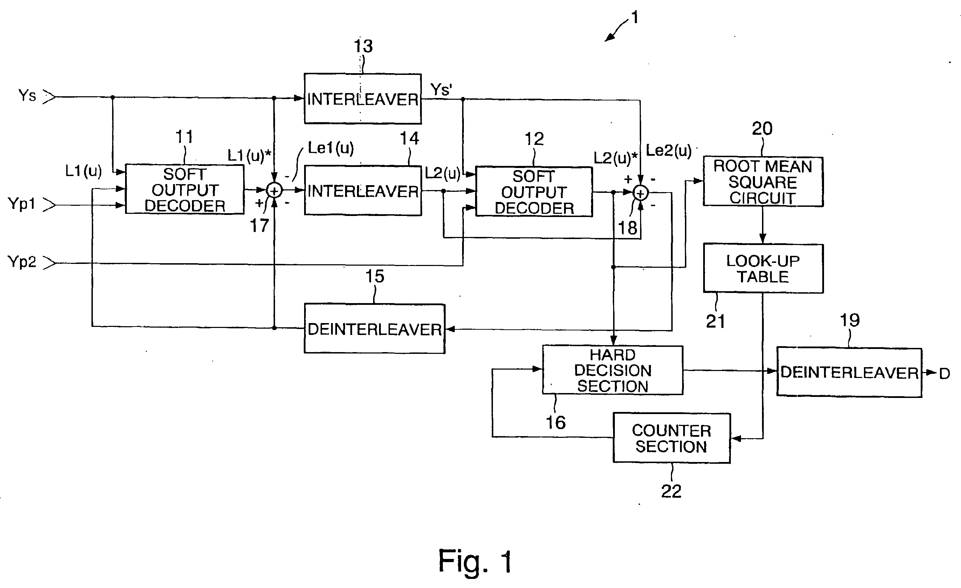

Fig. 1 is a block diagram of a turbo decoder of a first embodiment of the present invention.
Here, structural elements which are the same as those of the above-described turbo decoder 100 shown in Fig. 4 are denoted by the same reference numerals, and repeat description thereof is omitted.
A turbo decoder 1 shown in Fig. 1 differs from the turbo decoder 100 shown in Fig. 4 in that a root mean square circuit 20, a look-up table 21, and a counter section 22 are added.
The root mean square circuit 20 corresponds to the signal-to-noise ratio estimation section according to the present invention, and estimates the signal-to-noise ratio of a block under processing, based on the soft output data $L_2(u)^*$ from the soft output decoder 12. Specifically, in order to estimate to what extent the block under processing is reliable (to what extent noise is included in the signal), the root mean square circuit 20 estimates the signal-to-noise ratio of the block by carrying out root mean square calculation of the soft output data $L_2(u)^*$.
Data, which expresses the correspondence relationship between the signal-to-noise ratio estimated at the root mean square circuit 20 and the number of iteration for carrying out turbo decoding, is stored in the look-up table 21. The number of iteration is determined according to the signal-to-noise ratio of the received data $Y_s$ and the encoded data $Y_{p1}$, $Y_{p2}$, and a desired BER (Bit Error Rate). In the present embodiment, the correlation between the signal-to-noise ratio of the received data $Y_s$, $Y_{p1}$, $Y_{p2}$ and the signal-to-noise ratio estimated at the root mean square circuit 20 is estimated in advance by simulation, and table data that show the correspondence relationship between the signal-to-noise ratio and the number of repeating times are prepared and stored in the look-up table 21. The signal-to-noise ratio at the point in time when the initial repetition (the first time or second time, or the minimum necessary number of repeating times) is carried out, which signal-to-noise ratio is estimated at the root mean square circuit 20, is input to the look-up table 21. The look-up table 21 outputs to the counter section 22 the number of iteration corresponding to the same signal-to-noise ratio as that signal-to-noise ratio.
The counter section 22 sets the number of iteration from the look-up table 21 as the count value, and each time the soft output data $L_2(u)^*$ is estimated by the soft output decoder 12, decrements the count value by 1. When the count value reaches '0', the hard decision by the hard decision section 16 is terminated.
When the received data $Y_s$, $Y_{p1}$, $Y_{p2}$ are input to the turbo decoder 1 configured in this way, at the turbo decoder 1, the soft output data $L_2(u)^*$ is estimated at the soft output decoder 12, as is described with reference to Fig. 2. The estimated soft output data $L_2(u)^*$ is input to the root mean square circuit 20.

At the root mean square circuit 20, by carrying out root mean square calculation of the soft output data $L_2(u)$ *, the signal-to-noise ratio of that block is estimated. The estimated signal-to-noise ratio is compared with table data stored in the look-up table 21, and the number of iteration times, which corresponds to the same signal-to-noise ratio as the input signal-to-noise ratio, of the table data is output to the counter section 22.

At the counter section 22, the output number of iteration is set as the count value, and the count value is decremented whenever the soft output data $L_2(u)$* of the soft output decoder 12 is generated. As the result of decrementing, if the count value has not reached '0', the turbo decoding continues to be carried out. On the other hand, if the count value has reached '0', the hard decision by the hard decision section 16 is terminated.

Further, in the present embodiment, in place of the counter section 22, a comparing section that compares a predetermined value and the signal-to-noise ratio may be provided, and turbo decoding may be repeated until the signal-to-noise ratio reaches the predetermined value. In this way, the counter operation can be rendered unnecessary.

In this way, in the turbo decoder 1 of the present embodiment, root mean square for the soft output data $L_2(u)$* of the soft output decoder 12 is operated at the root mean square circuit 20, and the signal-to-noise ratio of the block under processing is estimated, and turbo decoding is carried out a number of times corresponding to that signal-to-noise ratio. Thus, in a case in which a block including a less noise is received, turbo decoding is carried out a smaller number of times. Accordingly, as compared with the conventional turbo decoder in which the number of iteration is set considering the worst signal-to-noise ratio, excessive repetitions can be prevented and a reduction in the power consumption can be achieved in a case in which a block having a relatively high signal-to-noise ratio is received.

Note that, in the present embodiment, root mean square for the soft output data $L_2(u)$* of the soft output decoder 12 is operated, and the signal-to-noise ratio of the block under processing is estimated. However, root mean square for the external likelihood information $Le_2(u)$ of the computing unit 18 may be operated, and the signal-to-noise ratio of the block under processing may be estimated.

Moreover, in the present embodiment, an example is described by estimating the signal-to-noise ratio of the block by carrying out root mean square calculation. However, the present invention is not limited to this, and the signal-to-noise ratio of a block under processing may be estimated on the basis of reliability information output of the decoding section.

Further, in the present embodiment, an example is described in which the look-up table 21 is referred to, and the number of iteration corresponding to the signal-to-noise ratio estimated at the root mean square circuit 20 is estimated, and by decrementing at the counter section 22, turbo decoding is carried out by that number of iteration. However, in the present invention, turbo decoding may be carried out by a number of times corresponding to the signal-to-noise ratio estimated at the signal-to-noise ratio estimation section.

Fig. 2 is a block diagram of a turbo decoder of a second embodiment of the present invention.

Here as well, structural elements which are the same as those of the above-described turbo decoder 100 shown in Fig. 4 are denoted by the same reference numerals, and repeat description thereof is omitted.

A turbo decoder 2 shown in Fig. 2 differs from the turbo decoder 100 shown in Fig. 4 in that a root mean square circuit 30, a look-up table 31, and input level adjustment sections 32, 33, 34 are added. Note that the soft output encoders 11, 12, the interleavers 13, 14, the deinterleavers 15, 19, the hard decision section 16, and the computing units 17, 18 correspond to the decoding section in the present invention.

The root mean square circuit 30 corresponds to the signal-to-noise ratio estimation section in the present invention, and, on the basis of the soft output data $L_2(u)$* from the soft output encoder 12, estimates the signal-to-noise ratio N(u) of a block under processing. Specifically, in order to estimate to what extent the block under processing is reliable (to what extent the signal-to-noise ratio N(u) is included), the root mean square circuit 30 estimates the signal-to-noise ratio N(u) of that block by carrying out root mean square calculation of the soft output data $L_2(u)$*.

Data that represents the correspondence relationship between the signal-to-noise ratio estimated at the root mean square circuit 30 and the IER is stored in the look-up table 31. IER (Input to Extrinsic data Ratio) is the ratio of the input data to the external likelihood information (Extrinsic Information), and a constant relationship exists between the IER and the signal-to-noise ratio of the input data. Here, in the present embodiment, the correlation between the signal-to-noise ratio of the input data and the signal-to-noise ratio estimated at the root mean square circuit 30 is estimated in advance by simulation, and data that show the correspondence relationship between the signal-to-noise ratio and the IER is prepared and stored in the look-up table 31. The look-up table 31 outputs to the input level adjustment sections 32, 33, 34 the IER corresponding to the signal-to-noise ratio estimated at the root mean square circuit 30.

Received data $Y_s = (Y_1{}^s, Y_2{}^s, ..., Y_N{}^s)$ and encoded data $Y_{p1} = (Y_1{}^{p1}, Y_2{}^{p1}, ..., Y_N{}^{p1})$, $Y_{p2} = (Y_1{}^{p2}, Y_2{}^{p2}, ..., Y_N{}^{p2})$ are input in block units to the input level adjustment sections 32, 33, 34, respectively. At the input level adjustment sections 32, 33, 34, in a case in which the IER output from the look-up table 31 is small, i.e., in a case in which the reliability of the received data $Y_s$ and the encoded data $Y_{p1}$, $Y_{p2}$ is high, these data $Y_s$, $Y_{p1}$, $Y_{p2}$ are amplified by a small amplification rate so as to estimate results of decoding centered around the data $Y_s$, $Y_{p1}$, $Y_{p2}$. On the other hand, in a case in which the IER output from the look-up table 31 is large, i.e., in a case in which the reliability of the received data $Y_s$ and the encoded data $Y_{p1}$, $Y_{p2}$ is low, these data $Y_s$, $Y_{p1}$, $Y_{p2}$ are amplified by a large amplification rate so as to estimate results of decoding centered around the calculation results of the aforementioned decoding section.

In this way, at the turbo decoder 1 of the present embodiment, root mean square for the soft output data $L_2$(u)* of the soft output decoder 12 is operated at the root mean square circuit 30 and the signal-to-noise ratio N(u) of the block under processing is estimated. In accordance with the estimated signal-to-noise ratio N(u), the levels of the input data $Y_s$, $Y_{p1}$, $Y_{p2}$ are adjusted at the input level adjustment sections 32, 33, 34. Thus, on the basis of the reliability output information within the turbo decoder 1, the signal-to-noise ratio N(u) of the block that is currently under processing is estimated, and the constant $L_c$ determined by the signal-to-noise ratio of the input data $Y_s$, $Y_{p1}$, $Y_{p2}$, is automatically set appropriately. Accordingly, there is no deterioration in the error correcting ability due to a difference between the constant $L_c$ calculated by the control processor and the constant $L_c$ actually to be used at the turbo decoder 100, as in the conventional turbo decoder 100. Further, a deterioration in the processing ability in order to calculate the constant $L_c$ is prevented, and processing abilities are improved while maintaining the error correcting ability, result in a reduction in power consumption as well.

Note that, in the present embodiment, root mean square for the soft output data $L_2$(u)* of the soft output decoder 12 is operated, and the signal-to-noise ratio N(u) of the block under processing is estimated. However, root mean square for the external likelihood information $Le_2$(u) of the computing unit 18 may be operated and the signal-to-noise ratio N(u) of the block under processing may be estimated.

Moreover, in the present embodiment, an example is described in which the signal-to-noise ratio of the block is estimated by carrying out root mean square calculation. However, the present invention is not limited to this, and the signal-to-noise ratio of the block that is under processing may be estimated on the basis of reliability information output of the decoder section.

Further, in the present embodiment, the level of the input data is adjusted according to the IER from the look-up table 31. However, the present invention is not limited to this, and the level of the input data may be adjusted according to the signal-to-noise ratio estimated at the signal-to-noise ratio estimation section.

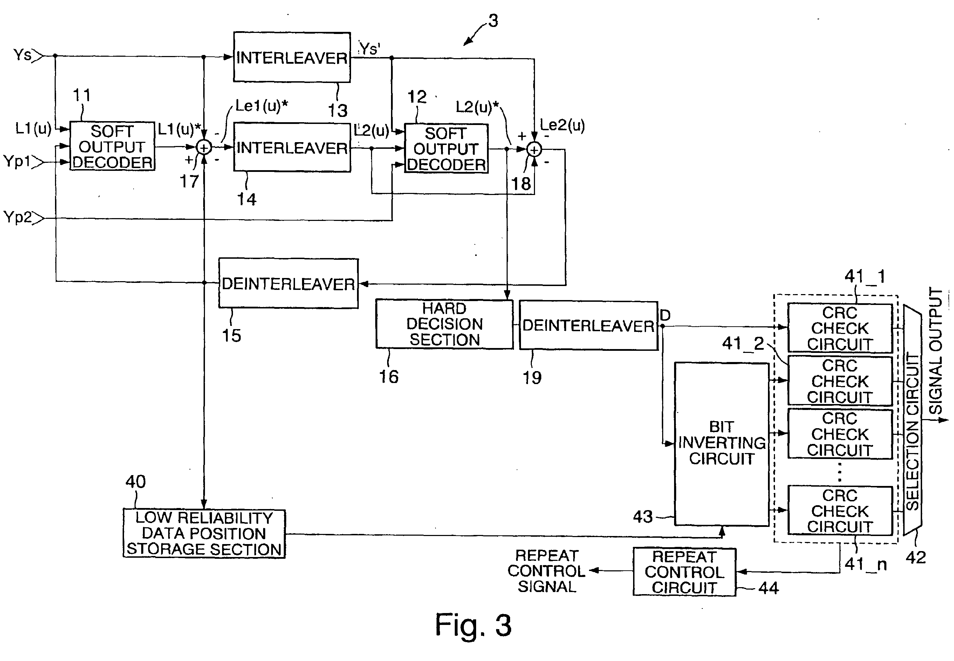

Fig. 3 is a block diagram of a turbo decoder of a third embodiment of the present invention.

Here, structural elements which are the same as those of the above-described turbo decoder 100 shown in Fig. 4 are denoted by the same reference numerals, and repeat description thereof is omitted.

A turbo decoder 3 shown in Fig. 3 differs from the turbo decoder 100 shown in Fig. 4 in that a low reliability data position storing section 40, CRC check circuits 41_1, 41_2, ..., 41_n, a selection circuit 42, a bit inverting circuit 43, and a repeat control circuit 44 are added.

The combination of the soft output decoders 11, 12, the interleavers 13, 14, the deinterleaver 15, and the computing units 17, 18 corresponds to the repeat decoding section of the present invention. Further, the CRC check circuits 41_1, 41_2, ..., 41_n, the selection circuit 42, the bit inverting circuit 43, and the repeat control circuit 44 correspond to the CRC check section in the present invention.

The low reliability data position storing section 40 stores one or more of the low reliability data positions among the priori likelihood information $L_1$(u) output from the deinterleaver 15. In other words, each time the repeat decoding section including the soft output decoders 11, 12, the interleavers 13, 14, the deinterleaver 15, and the computing units 17, 18 repeats the decoding process, the low reliability data position storing section 40 stores one or more of the low reliability data positions among the soft decision results at the repeated process of this time.

The bit inverting circuit 43 inverts the logic of the data of the data position stored in the low reliability data position storing section 40 among the decoded data sequence D that is obtained at the hard decision section 16 and deinterleaved at the deinterleaver 19, and generates a data sequence for CRC check. For example, in a case in which there are two stored data positions, the data sequence for CRC check is generated three ways (excluding the original data sequence). In the present embodiment, data sequences for CRC check are generated in a maximum of n-1 ways.

The data sequences 1, ..., n-1 from the bit inverting circuit 43, and the data sequence D that is from the deinterleaver 19 and has not passed through the bit inverting circuit 43, are input to the CRC check circuits 41_1, 41_2, ..., 41_n. At the CRC check circuits 41_1, 41_2, ..., 41_n, CRC check of the input data sequences D, 1, ..., n-1 for CRC check is simultaneously carried out. In a case in which it is determined that there is no error in the CRC check results at any one of the CRC check circuits among the CRC check circuits 41_1, 41_2, ..., 41_n, an acknowledge signal is output to the repeat control circuit 44.

The repeat control circuit 44 receives this signal, and outputs a control signal for terminating the repeating of the turbo decoding process. In this way, the repeating of the decoding process at the repeat decoding section including the soft output decoders 11, 12, the interleavers 13, 14, the deinterleaver 15, and the computing units 17, 18 is terminated.

The selection circuit 42 selects the data sequence at the CRC check circuit, for which it was judged that there was no error in the CRC check results, among the CRC check circuits 41_1, 41_2, ..., 41_n, and outputs the data sequence as decoded data.

In this way, at the turbo decoder 3 of the present embodiment, the low reliability data position among the soft decision results at this time of the repeated processes is stored in the low reliability data position storing section 40.

The data logic of the data position stored in the low reliability data position storing section 40 is inverted, and is CRC checked with the data sequence D. In a case in which it is judged that there is no error in the CRC check results, the repeating of the decoding process is terminated. Thus, for example, in a case in which noise is included in one portion of a data sequence due to occurrence of fading, the logic of only data that includes the noise in the data sequence is inverted and is CRC checked. Accordingly, the probability it will be judged, in the CRC check, that there is no error increases. As compared with the technique disclosed in the previously-mentioned thesis (1999 IEEE Intnl. Symp. on Low Power Design), the time until it is judged, in the CRC check, that there is no error can be shortened, and the processing speed can be improved while the error correction ability is maintained, and an even further reduction in power consumption can be achieved. Further, as compared with the technique disclosed in Japanese Patent Laid-open Gazette No. 10-303759 in which soft decision data is decoded into a bit sequence, reliability information is added to the bit sequence, and CRC check is carried out, the time required for carrying out CRC check can be shortened, and from this standpoint as well, the processing speed can be improved. Moreover, because the CRC check is carried out simultaneously at the CRC check circuits 41_1, 41_2, ..., 41_n, the processing speed of the CRC check can be made even more fast.

**Claims**

1. A turbo decoder to which turbo encoded data is input in block units and which carries out turbo decoding comprising:

    a decoding section for inputting the data and carrying out turbo decoding; and
    a signal-to-noise ratio estimation section for estimating a signal-to-noise ratio of a block under processing on the basis of reliability information output of the decoding section,

    wherein the decoding section carries out a process of repeating turbo decoding by a number of times corresponding to the signal-to-noise ratio estimated at the signal-to-noise ratio estimation section.

2. A turbo decoder according to claim 1, wherein the signal-to-noise ratio estimation section has a root mean square circuit that operates a root mean square of soft output data or external likelihood information, and estimates the signal-to-noise ratio of the block under processing.

3. A turbo decoder according to claim 1, wherein the turbo decoder has a comparing section that compares the signal-to-noise ratio and a predetermined value, and the decoding section repeats turbo decoding until the signal-to-noise ratio estimated at the signal-to-noise ratio estimation section reaches the predetermined value.

4. A turbo decoder according to claim 1, wherein the turbo decoder has a look-up table that stores a correspondence relationship between signal-to-noise ratios and numbers of repeating turbo decoding, and
    the decoding section repeats turbo decoding by a number of times corresponding to the signal-to-noise ratio estimated at the signal-to-noise ratio estimation section, according to the look-up table.

5. A turbo decoder according to claim 1, wherein the turbo decoder has a counter section that counts a number of repeating turbo decoding, and
    the decoding section terminates hard decision, after a number of times corresponding to the signal-to-noise ratio estimated at the signal-to-noise ratio estimation section has been counted at the counter section.

6. A turbo decoder to which turbo encoded data is input in block units and which carries out turbo decoding comprising:

    a decoding section for inputting the data and carrying out turbo decoding;
    a signal-to-noise ratio estimation section for estimating a signal-to-noise ratio of a block under processing on the basis of reliability information output of the decoding section; and
    an input level adjusting section for adjusting a level of data input to the decoding section according to the signal-to-noise ratio estimated by the signal-to-noise ratio estimation section.

7. A turbo decoder according to claim 6, wherein the input level adjusting section amplifies the data at a low amplification rate in a case in which reliability of data input to the decoding section is relatively low, and at a high amplification rate in a case in which the reliability is relatively high.

8. A turbo decoder according to claim 6, wherein the signal-to-noise ratio estimation section has a root mean square circuit that operates a root mean square of soft output data or external likelihood information and estimates the signal-to-noise ratio of the block under processing.

9. A turbo decoder according to claim 6, wherein the turbo decoder has a look-up table that stores a correspondence relationship between signal-to-noise ratios and ratios of input data to external likelihood information, and
the input level adjusting section adjusts the level of the data input to the decoding section according to the signal-to-noise ratio estimated by the signal-to-noise ratio estimation section, in accordance with the look-up table.

10. A turbo decoder to which turbo encoded data is input in block units and which carries out turbo decoding comprising:

a repeat decoding section for inputting data sequences and repeating a decoding process accompanying a soft decision a plural number of times;
a hard decision section for generating a decoded data sequence by receiving soft decision results of decoding at the repeat decoding section and carrying out hard decision;
a CRC check section for carrying out CRC check for the decoded data sequence obtained at the hard decision section; and
a low reliability data position storing section for storing a low reliability data position among the soft decision results of decoding at the repeat decoding section,

wherein the CRC check section carries out CRC check on the decoded data sequence obtained at the hard decision section, and on the basis of the decoded data sequence, carries out CRC check also on a data sequence at which a logic of data of the low reliability data position stored in the low reliability data position storing section, among the decoded data sequence, is inverted.

11. A turbo decoder according to claim 10, wherein, each time the repeat decoding section repeats the decoding process, the low reliability data position storing section stores a low reliability data position among the soft decision results at a repeat process of this time, and

the CRC check section inverts the logic of the data of the data position stored at a repeat process of a previous time in the low reliability data position storing section, among the decoded data sequence obtained by the hard decision section, and carries out CRC check, and
the turbo decoder comprises a repeat control section which, in a case in which a data sequence is obtained for which it is judged that there are no errors in CRC check results at the CRC check section, terminates repeating of the decoding process at the repeat decoding section.

Fig. 1

EP 1 170 870 A1

Fig. 2

EP 1 170 870 A1

Fig. 3

EP 1 170 870 A1

200

TRANSMITTING SIDE

u   Xs

201
CONVOLUTIONAL CODER   Xp1

INTERLEAVER — 203

CONVOLUTIONAL CODER   Xp2

202

MODULATOR

300

COMMUNICATION PATH

400

NOISE

DEMODULATOR

500

100

RECEIVING SIDE

Ys

Yp1

Yp2

11
SOFT OUTPUT DECODER

L1(u)

L1(u)*

17

INTERLEAVER   Ys'

13

Le1(u)

INTERLEAVER

14

L2(u)

12
SOFT OUTPUT DECODER

L2(u)*

Le2(u)

18

DEINTERLEAVER

15

HARD DECISION SECTION

16

DEINTERLEAVER   D

19

Fig. 4

# INTERNATIONAL SEARCH REPORT

| | International application No. |
|---|---|
| | PCT/JP01/01030 |

**A. CLASSIFICATION OF SUBJECT MATTER**
Int.Cl⁷ H03M13/09, 13/23, 13/27, 13/39
Int.Cl⁷ H04L1/22

According to International Patent Classification (IPC) or to both national classification and IPC

**B. FIELDS SEARCHED**

Minimum documentation searched (classification system followed by classification symbols)
Int.Cl⁷ H03M13/09, 13/23, 13/27, 13/39
Int.Cl⁷ H04L1/22

Documentation searched other than minimum documentation to the extent that such documents are included in the fields searched

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP, 11-330984, A (Toshiba Corporation), 30 November, 1999 (30.11.99), Par. No. [0019] & WO, 98/58468, A & EP, 935363, A1 & JP, 11-191758, A & JP, 2001-7775, A | 1-11 |
| X | EP, 973292, A2 (NORTEL NETWORKS CORPORATION), 19 January, 2000 (19.01.00), Fig.6 & JP, 2000-101453, A | 1-11 |
| P,Y | JP, 2000-165258, A (YRP Idou Tsushin Kiban Gijutsu Kenkyusho K.K.), 16 June, 2000 (16.06.00), Par. No. [0028] (Family: none) | 1-11 |
| Y | JP, 10-303759, A (Mitsubishi Electric Corporation), 13 November, 1998 (13.11.98), Fig. 1 & CN, 1197334 & US, 6061823 | 10 |
| A | JP, 11-41110, A (Sanyo Electric Co., Ltd.), | 1-11 |

☒ Further documents are listed in the continuation of Box C.　☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier document but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 07 May, 2001 (07.05.01) | 22 May, 2001 (22.05.01) |

| Name and mailing address of the ISA/ | Authorized officer |
|---|---|
| Japanese Patent Office | |
| Facsimile No. | Telephone No. |

Form PCT/ISA/210 (second sheet) (July 1992)

| | INTERNATIONAL SEARCH REPORT | International application No. |
| | | PCT/JP01/01030 |

C (Continuation).   DOCUMENTS CONSIDERED TO BE RELEVANT

| Category* | Citation of document, with indication, where appropriate, of the relevant passages | Relevant to claim No. |
|---|---|---|
| | 12 February, 1999 (12.02.99)    (Family: none) | |

Form PCT/ISA/210 (continuation of second sheet) (July 1992)